# EUROPEAN PATENT SPECIFICATION

(11) **EP 2 223 582 B1**
(45) Date of publication and mention of the grant of the patent: **09.11.2011**
(21) Application number: 08858560.9
(22) Date of filing: 08.12.2008
(51) Int. Cl.: H05K 5/02, A44B 15/00, H01R 13/453

(54) **USB STICK**
USB-STICK
CLÉ USB

(30) Priority: 10.12.2007 BE 200700587
(43) Date of publication of application: 01.09.2010
(73) Proprietor: Provista Besloten Vennootschap Met Beperkte Aansprakelijkheid, 8380 Zeebrugge (BE)
(72) Inventor: CABES, Xavier, B-2000 Antwerpen (BE)
(74) Representative: Donné, Eddy
(86) International application number: PCT/BE2008/000100
(87) International publication number: WO 2009/073936

(56) References cited:
- DE-U1- 29 818 884
- DE-U1-202007 002 051
- US-A1- 2004 083 320
- US-A1- 2005 079 738
- US-A1- 2007 084 929

## Description

The present invention concerns a USB stick.

In particular, the invention concerns a USB stick of the type which mainly consists of a housing with a memory and a USB plug protruding from one edge of the housing.

It is known that such a conventional USB stick is provided with a cap which can be provided with its open side over the USB plug and which thus protects the USB plug when it is closed.

A disadvantage of such USB sticks is that the caps often get lost due to their small dimensions and are hard to find back.

That is why the cap is sometimes provided with fixing means with which it can be fixed to a bunch of keys, a necklet or the like.

However, this does not prevent the housing with the USB plug from coming off the cap while walking, exercising or the like, as a result of which the housing may get lost or the USB plug may become filthy, get damaged or become unusable, since it is no longer protected by a cap.

Also the housing may be provided with fixing means which make it possible, for example, to hang the USB stick on a bunch of keys.

These means are disadvantageous, however, in that when the USB stick is provided in a USB slot, the keys will pull at the USB stick, which may result in a bad contact, or in that the USB stick is extracted from the slot or the USB stick or the USB slot may even be damaged.

In certain computer embodiments it will not even be possible to connect the USB stick to the computer due to a lack of space around the computer's USB slot.

US 2005/0079738 discloses a USB stick of the type defined in the preamble of claim 1.

The present invention aims to remedy the above-mentioned and other disadvantages by providing a USB stick according to claim 1

An advantage is that the cap stays permanently fixed to the housing, as a result of which said cap cannot get lost when using the USB stick and to allow to hold the rotatable cap of the housing in the open portion with a certain resistane and to lock it as well in a closed portion.

In a preferred embodiment, the USB stick is provided with means for an at least temporary attachment of the USB stick to another object, whereby these means can be easily detached.

An advantage is that the USB stick can be attached to another object such as for example a key ring, a necklet and the like, such that said USB stick can be easily taken anywhere with a minimal risk of loss.

Another advantage is that the USB stick can be exchanged with different objects and that when the USB stick is attached to a necklet, for example, swapping the USB stick with another USB stick or another object can be done without necessarily having to untie the chain.

Yet another advantage linked thereto is that the USB stick and the object can be removed from one another when one wants to use the USB stick, such that the USB plug can be put directly in the slot of a computer or another appliance without being hindered by the object to which the USB stick had been attached.

Another advantage is that the USB stick can be designed as a jewel and can be carried as such, since the USB stick can be easily detached from a necklet or the like to be connected to a computer.

In order to better explain the characteristics of the invention, the following embodiments of a USB stick according to the invention are described by way of example only without being limitative in any way, with reference to the accompanying drawings, in which:
figure 1 schematically shows a view of a USB stick according to the invention when closed, seen in perspective;
figure 2 shows a view according to arrow F2 in figure 1;
figure 3 shows a section of the USB stick according to line III-III in figure 2 when closed;
figures 4 and 5 represent the USB stick of figure 3 in two different positions;
figure 6 is an enlargement of the part indicated by F6 in figure 5;
figure 7 is a figure analogous to that in figure 6, but in another position;
figures 8 and 9 represent an alternative embodiment of the USB stick, shown in two positions;
figure 10 shows a section as that in figure 3, but for yet another embodiment of the USB stick;
figure 11 represents a view according to line XI-XI in figure 10 of a part of the means for fixing the USB stick to another object.

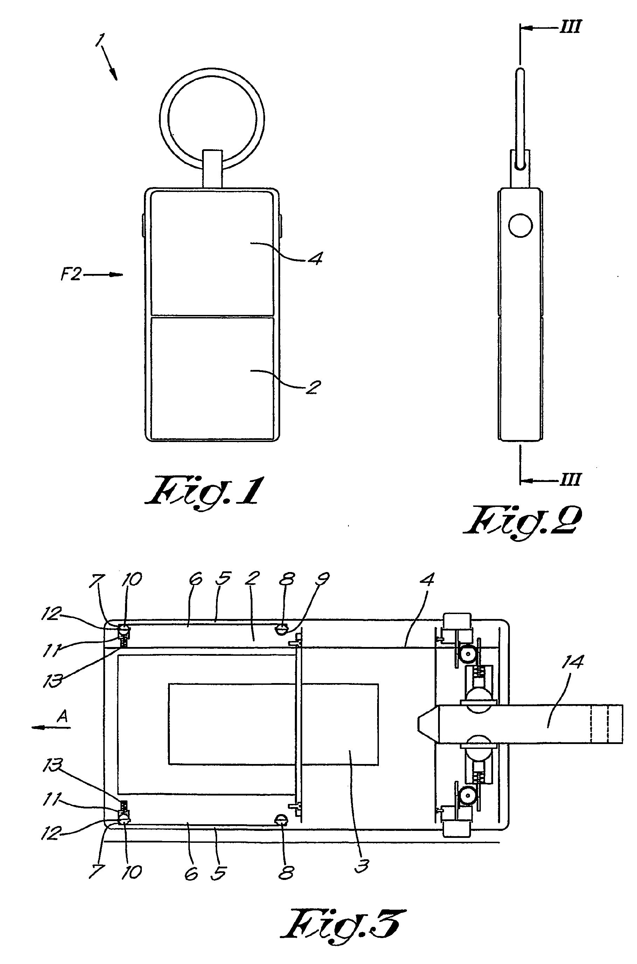

Figures 1 to 3 schematically represent a USB stick 1 according to the invention which mainly consists of a housing 2 with a memory and of a USB plug 3 protruding from the edge of the housing 2 and a cap 4 which can be provided with its open side over the USB plug 3.

The USB stick 1 is further provided with means to connect the cap 4 and the housing 2 to one another, made as two parallel arms 5 in the given embodiment, which are fixed on the cap 4 and which protrude over a length in relation to the open side of the cap 4, such that the housing 2 is slidable and rotatable between said arms 5 in the longitudinal direction of the arms 5.

In each of the sides of the arms 5 that are directed towards one another is provided a groove 6 in the longitudinal direction of the arms 15, up to a short distance from the free end of the arm concerned, such that a stop 7 is formed at the free end defining the length of the groove 6.

The housing 2 is provided with at least two protrusions 8, each on a side edge of the housing 2, which are each mounted slidably in one of the above-mentioned grooves 6, and which are partly situated in a recess 9 provided to that end in the side edge of the housing 2.

These protrusions 8 are preferably situated at two corners of the housing 2, on the edge from which the USB plug 3 protrudes.

Said protrusions 8 can be made in the shape of balls.

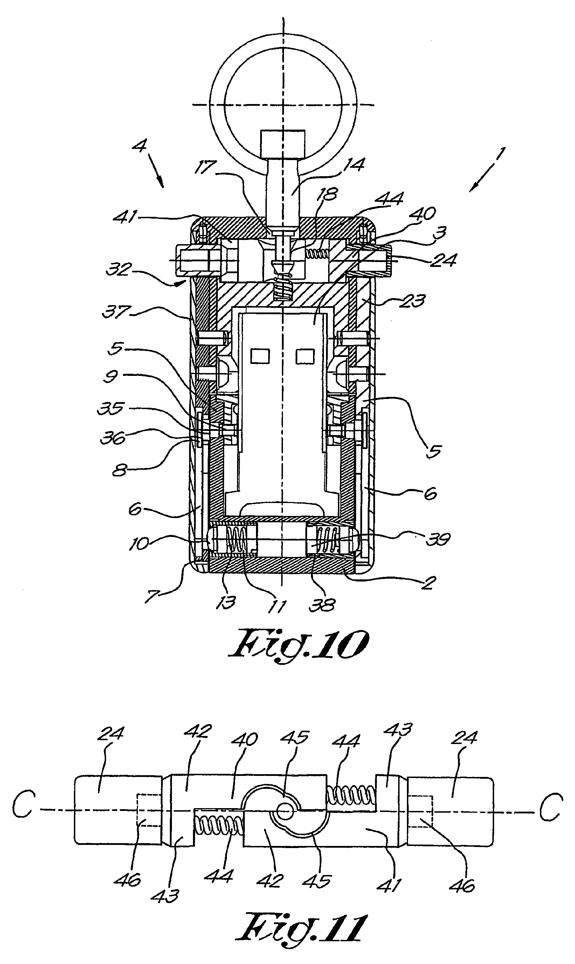

In a preferred embodiment, however, the protrusions 8 are made as represented in figure 10. Such a protrusion 8 is formed of the free end of a pen 35 to which a plate 36 is fixed at the other end in such a manner that the plate 36 is at right angles to the axis of the pen 35.

In this embodiment, the groove 6 is provided in the arms 5 over the entire thickness of said arms 5. In the sides of the arms 5 which are directed away from one another, an additional undercut has been provided along the perimeter of the groove 6.

Things are made such that said pen can be put with its free end along the outside of the arms 5 through the groove 6.

After having been mounted, the plate 36 rests in the undercut on the arms 5. Said plate 36 may for example be circular.

The protrusion 8, formed of the free end of the pen 35, can be placed in the recess 9 provided to that end in the side edge of the housing 2.

Said free end of the pen 35 may possibly be provided with a screw thread working in conjunction with a screw thread that has been provided in the recess 9.

It is also possible to provide an axial bore hole in the pen 35 with a plate 36 through which a screw can be provided to thus fix the protrusion 8 in the recess 9, in which a screw thread is then provided working in conjunction with said screw.

The arms 5 further comprise a cover plate 37 provided on the sides which are directed away from one another and which thus covers the groove 6 and the undercut on the outside.

The protrusions 8 are preferably made of a material having a low coefficient of friction, such as Teflon for example.

Additional protrusions 10 may possibly be provided which are preferably situated at the two other corners of the housing 2, the latter protrusions 10 being partly held in a recess 11 provided to that end in the side edges of the housing 2.

In a first embodiment, as shown for example in figure 3, both said protrusions 10 are maintained in the recess 11 by means of a ring 12 which covers the recess 11 and whose inner diameter is smaller than the diameter of the protrusion 10.

This recess 11 is provided with a compressed spring 13 which pushes the protrusion 10 against the above-mentioned ring 12.

Figure 10 shows an alternative embodiment of the protrusions 10. These protrusions 10 are hereby held in a case 38 which is fixed in the recess 11, for example by means of gluing or by means of a screw connection.

At one far end, said case 38 is provided with an inner collar. The protrusion 10 is formed of a pen provided with a stop. When the pen is put in the case 38, the far end of said pen can protrude from the case 38.

The movement of the pen out of the case 38 is restricted as the stop at the pen ends up against the inner edge of the case 38.

When the pen is situated in the case 38, the spring 13 is put in the case 38 and fixed under tension by closing the case 38 by means of an element 39.

When the mounted case 38 is fixed in the recess 11 of the housing 2, the protrusion 10 can move in and out of the recess 11 by either or not exerting an axial force thereon.

Preferably, the free far end of the protrusion 10 is partly or entirely rounded.

The method for opening the USB stick is very simple and as follows, and it is illustrated by means of figures 3 to 5.

In its closed position, as represented in figures 1 to 3, the USB plug 3 is protected by the cap 4 which is provided with its open side over the USB plug 3.

If one wants to use the USB stick 1 and thus detach the housing 2 with the USB plug 3 from the cap 4, a force A according to the longitudinal direction of the arms 5 will be exerted on the housing 2, as a result of which the housing 2 shifts in relation to the cap 4 according to the longitudinal direction of the arms 5.

The protrusions 10 will hereby be pushed over the stop 7 in the recesses 11, against the force of the springs 13, until the far end of the housing 2 has moved sufficiently, which makes it possible indeed to withdraw the housing 2 from the cap 4.

During said movement, the grooves 6 in the arms 5 form a guide for the other protrusions 8.

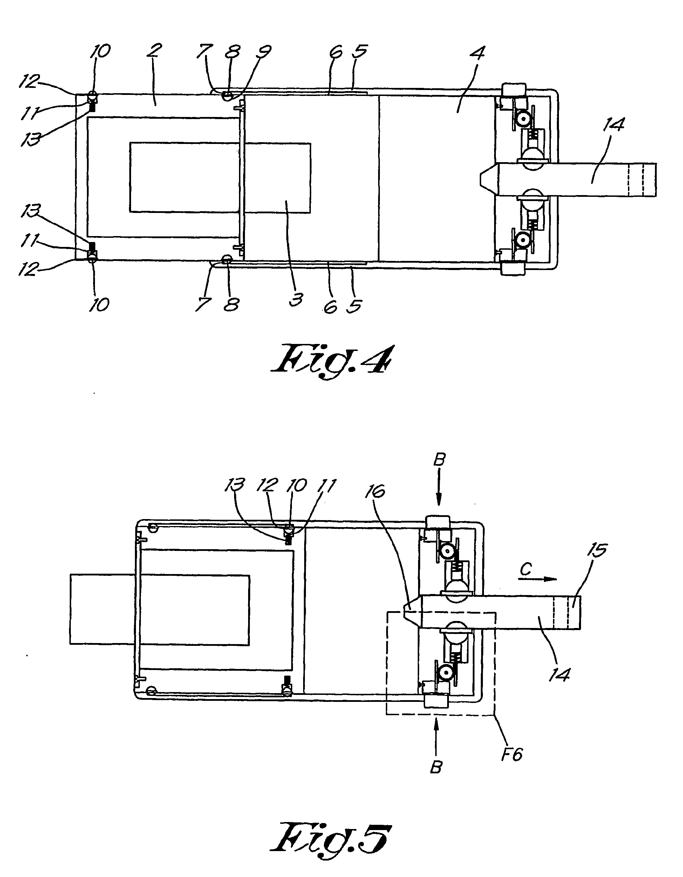

The sliding movement will be stopped as soon as the protrusions 8 are situated against the stops 7 of the grooves 6, as represented in figure 4.

The housing 2 is slidable over a length which depends on the length of the groove 6, which is such that the housing 2 is slidable over a length which is at least sufficient to draw the USB plug 3 out of the cap 4.

Next, the housing 2 can be rotated around the geometrical axis by the two protrusions 8 which are still situated in the groove 6 after the sliding movement.

It is hereby possible to rotate the housing 2 over an angle of 180° such that, as represented in figure 5, the USB plug 3 will be situated on the outside of the USB stick 1, ready for use.

In this condition of use, the housing 2 will be held with a certain resistance thanks to the springy action of the protrusions 10 which make contact with the arms 5 during the rotational movement of the housing 2 around the above-mentioned geometrical axis, after which, as it rotates further, the protrusions 10 are pushed in the grooves 6 of the arms 5 and thus lock the housing 2.

As can be seen in figure 5, the protrusions 10 are preferably situated at the far ends of the groove 6, such that the housing 2 is also locked in the longitudinal direction in the situation as represented, and it is therefore held in place when the USB plug 3 is put in a USB slot.

The method for closing off the USB stick is very simple and as follows.

By exerting a force perpendicular to the surface of the USB plug 3, and preferably as close as possible to the other side of the housing 2 than the one from which the USB plug 3 protrudes, the protrusions 10 will in their respective recesses 11 again be pushed by the edges of the grooves 6 in the arms 5, as a result of which the springs 13 are compressed.

When further pushing, the protrusions 10 pass the sides of the arms 5, and the springs 13 in the recesses 11 are released again, such that they partly push the protrusions 10 out of the recesses 11 again.

The housing 2 can be rotated until the housing 2 and the cap 4 are situated in one another's prolongation again, as represented in figure 4, whereby the USB plug 3 is turned towards the open side of the cap 4.

By exerting a force in the direction of the cap 4, the protrusions 8 which are situated in the grooves 6 of the arms 5 will move along the longitudinal direction of the groove 6.

During this sliding, the protrusions 10 at the free far end of the housing 2 will bump into the edges of the arms 5 and they will thus be pushed in the recesses 11 as the springs 13 are compressed.

Small notches may possibly be provided in the arms 5, such that the protrusions 10 only have to be pushed partly in the recesses 11.

During further sliding, the springs 13 will be released again as the protrusions 10 are situated partly in the grooves 6 in the arms 5.

In this manner, the USB stick 1 is put in a stable, closed position, and the USB plug 3 is protected by the cap 4.

The USB stick 1 may further be provided with means which make it possible to fix the USB stick 1 either or not temporarily to another object, such as for example a key ring or a chain, whereby these means may be detachable, for example by means of a quick coupling.

In the described embodiments as shown in the figures, said fixing means are made in the shape of a pen 14 which may be connected to an object of one's choice at its far end 15, and which may be provided in a detachable manner in a bore hole 17 of the USB stick 1 at its other far end. In the far end 16, along the perimeter of the pen 14, is provided a groove 18.

The bore hole 17 is preferably situated in the cap 4 of the USB stick 1.

In a first embodiment, the bore hole is provided with at least one radially directed seat 19 in which can be provided a ball 20.

In figures 3-7, two balls 20 have been provided, situated partly in the groove 18 of the pen 14, whereby the above-mentioned balls 20 can co-operate with the above-mentioned groove 18 in the pen 14 by means of a spring 21.

In this embodiment, the USB stick 1 is further provided with means to eliminate the action of the spring 21 on the ball 20.

In the embodiment represented in figures 3-7, said means are formed of an element 22 in the form of a slide situated in a guide according to the axial direction of the radial seat 19, which element 22 has been provided between the ball 20 and the spring 21 and a mechanism 15 which makes it possible to withdraw the element 22 in the direction of the bore hole 17.

Said mechanism is preferably integrated in a body 23 which is provided with two control buttons 24 which can be pushed in a recess 25 of the body 23 provided to that end.

Said control buttons 24 are each connected to a mechanism formed of two parallel gear racks 26,27 provided slidably in the body 23 in a direction which is parallel to the axial direction of the radial seat 19, and of a gear wheel 28 which is provided in a freely rotating manner between both gear racks 26,27 and which meshes in the teeth of both gear racks 26,27.

One of the gear racks 27 is connected to the above-mentioned element 22 between the spring 21 and the ball 20, whereas the other gear rack 26 which is connected to the control button 24 has been provided in a guide 29.

The body 22 may be further provided with recesses 30 in which locking screws or locking pins 31 may be provided, said recesses 30 ending in the recesses 25 of the control buttons 24.

The method for removing the fixing pen 14 is very simple and as follows.

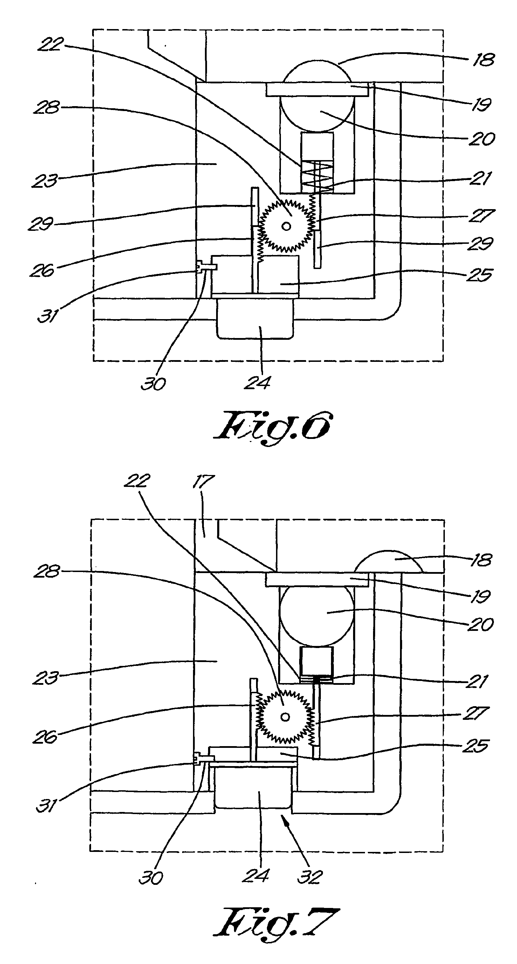

Figure 6 shows the situation in which the pen 14 is locked in the housing 2 as the balls 20 are pushed in the groove 18 of the pen 14 by means of the springs 21.

In order to be able to remove the pen 14 from the housing 20, the control buttons 24 are pushed in towards one another in the direction of the arrows B in figure 5, as a result of which the mechanism of the two gear racks 26,27 and the gear wheel 28 is activated, whereby the gear rack 26 moves in its guide 29, such that the gear wheel 28 starts to rotate and the gear rack 27 which is connected to the element 22 is set in motion in a direction opposite to the direction of movement B.

The length of the guide 29 is selected such that the gear rack 26 can shift over the required distance and prevents the control buttons 24 from being pushed in too deeply, such that the mechanism cannot be forced.

Thanks to the shifting of the gear racks 27, the elements 22 are withdrawn from the pen 14 against the action of the springs 21, such that the balls 20 can freely move in their radial seat 19 and as a result of which the pen 14 can be removed from the bore hole 17, as is shown in figure 7 which represents an intermediate position when withdrawing the pen 14 in the direction of the arrow C in figure 5.

The method for fixing the USB stick 1 to another object is very simple and as follows.

The pen 14, which can be connected to another object, can be pushed in the bore hole 17 provided to that end.

The pen 14 will hereby push against the balls 20 in the radial seat 19 of the bore hole 17, such that said balls 20 are pushed in a radial direction, away from the pen 14, and compress the spring 21 which is connected to the ball 20 via the element 22.

When the pen 14 is shifted further in the USB stick 1, the groove 18 in the pen 14 will be situated at a given moment under the radial seat 19 with the balls 20, the balls 20 being pushed in the groove 18 by the springs 21, and the fixing pen 14 being thus firmly connected to the USB stick 1.

It should be noted that, as is shown in figures 5 to 7, the above-mentioned body 23 is a block-shaped part which is provided in the cavity of the cap 4 of the USB stick 1, said body 23 being held in the cap 4 as the control buttons 24 protrude through passages 32 in the cap 4, the locking screws 31 preventing the buttons 24 from being pushed in too deeply, as a result of which the body 23 would be possibly released.

This type of mounting moreover makes it possible to apply the above-mentioned mechanism in a very simple manner in the cap 4 during the assembly of the USB stick 1, in the following manner.

The body 23 is pushed in the cap 4 via the open side by pressing the control buttons 24 against the force of the springs 21.

The control buttons 24 are thereby pressed entirely in their recesses 25 and they are held in this position by the locking screws 31, such that the control buttons do not form a protruding part on the body 23 and cannot be damaged while the body 23 is being inserted.

As soon as the body 23 has been pushed sufficiently far in the cap 4, such that the control buttons are situated at the provided passages, the locking screws 31 will be unscrewed, such that the springs 21 are released and the control buttons 24 are pushed through the passages 32 to the outside of the USB stick 1.

As soon as the control buttons 24 are situated on the outside of the USB stick, they will be fastened again by means of the locking screws 31.

In this manner, the body 23 will be locked in the cap 4 when mounted since the control button 24, under the influence of the above-mentioned spring 21, snaps into a passage 32 of the cap 4, and the movement of the control buttons 24 will be restricted by the locking screws 31, such that the control buttons 24 cannot be pushed in too deeply.

The body 23 can be removed from the cap 4 in a very simple manner by unscrewing the locking screws 31 and by pressing the control buttons 24, by fastening them again such that they become locked in their recesses 25, after which the body 23 can be removed from the cap 4.

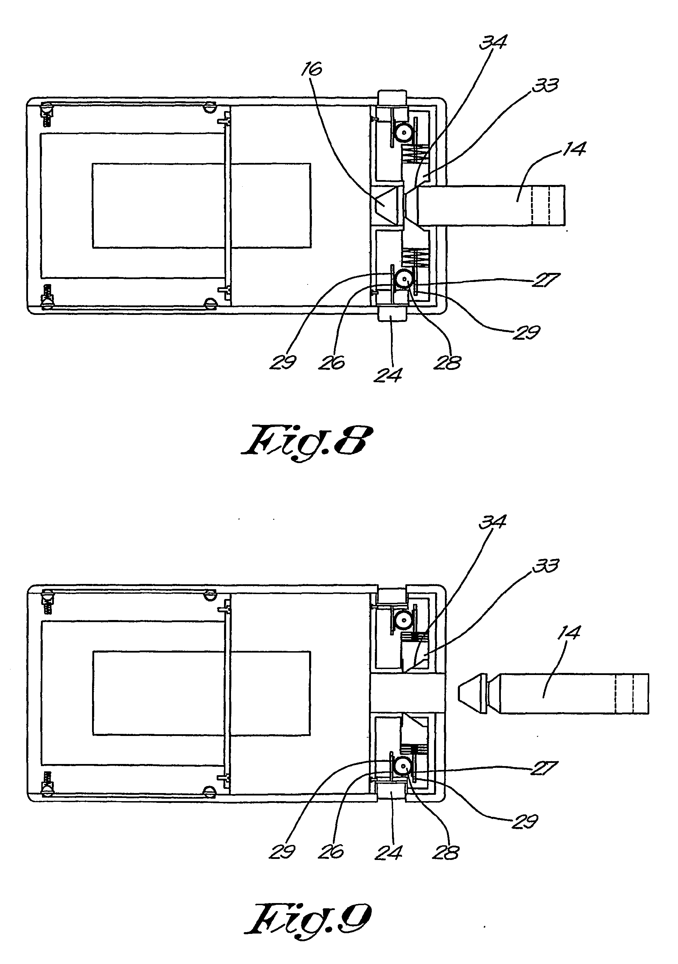

In another embodiment, as represented in figure 8 and 9, the balls 20 have been replaced by pens 33 which are preferably wedge-shaped and which can work in conjunction with a wedge-shaped groove in the pen 14, the slanting part 34 of the pens 33 having a slope towards the bore hole 17 in the direction of the interior of the cap 4.

The far end 16 of the pen 14 can also be provided with a conical shape having the same slope as the pens 33, such that when the pen 14 is inserted, it can co-operate with the pens 33 and push them against the direction of the spring 21.

Naturally, the pens 33 may also have other shapes such as for example cylindrical elements.

Figures 10 and 11 show another variant of an embodiment of the means which make it possible to fix the USB stick 1 either or not temporarily to another object.

These means mainly comprise two slide-shaped elements 40,41 which can co-operate to partly seal the hole of the bore hole 17 in the USB stick 1 over a limited distance of said bore hole 17.

Figure 11 shows that these slide-shaped elements 40,41 have a predominantly L-shaped section. The slide-shaped elements 40,41 are positioned in relation to one another in such a way that their long legs 42 partly overlap. The short legs 43 point in the direction of the other slide-shaped element 40,41, at least seen in relation to the longitudinal direction of the long legs 42.

Between the short leg 43 of the one slide-shaped element 40,41 and the far end of the long leg 42 of the other slide-shaped element 40,41 are provided springs 44.

In each of the sides of the long legs 42 that are directed towards each other are provided two partly overlapping semi-circular passages. One passage has a larger diameter than the other one, such that in a specific position of the two slide-shaped elements 40,41, when the springs 44 are released somewhat more, the two smaller semi-circular passages are situated opposite one another and thus together form a small circular passage. When the two slide-shaped parts 40,41 are brought towards one another from this position, the common passage will become larger, until a position is reached in which the two larger semi-circular passages are situated opposite one another and thus together form a large circular passage.

On one side, the edges 45 of the opening of the slide-shaped elements 40,41 are bevelled towards the inside.

On the sides of the slide-shaped elements 40,41 that are directed away from one another are provided studs 46 over which the control buttons 24 can be provided.

This mechanism is preferably integrated in a body 23 which can be provided in the cap 4, such that the control buttons 24 can be operated from outside, on the side of the USB stick 1.

The method for removing the pen 14 is very simple and as follows.

In the initial position, the pen 14 is locked in the housing 2. As the control buttons 24 are not pressed, the slide-shaped elements 40,41 are positioned to each other in such a way that they partly cover the hole of the bore hole 17. The part of the pen 14 over which the groove 18 is provided is enclosed by said sealing.

In this condition however, the hole formed by the slide-shaped elements 40,41 is not so large that the entire diameter of the pen 14 can move through it. If the pen 14 is being drawn at, the edge of the pen 14 formed by the groove 18 will remain hooked on the slide-shaped elements 40,41.

If the control buttons 24 are pressed in towards one another according to the direction of the arrows C in figure 11, the slide-shaped elements 40,41 will shift in relation to one another, against the resistance of the springs 44. As a result, the hole formed by the slide-shaped elements 40,41 will become larger than the full diameter of the pen 14, such that the latter can be drawn from the bore hole 17 or can be automatically pushed out of the latter by means of a spring.

Also the method for fixing the USB stick 1 to another object is very simple and as follows.

The pen 14, which can be connected to another object, can be pushed in the bore hole 17 provided to that end.

The pen 14 shall hereby push against the bevelled edge 45 of the slide-shaped elements 40,41. As a result, the slide-shaped elements 40,41 will move away from each other, against the pressure of the springs 44, such that the free opening between these elements becomes larger.

When the pen 14 is pushed further in the USB stick 1, the opening will be large enough in order to let the full diameter of the pen 14 go through.

When, at a given moment, the groove 18 ends up in the pen 14 at the slide-shaped elements 40,41, said slide-shaped elements 40,41 will move towards each other again due to the pressure of the springs 44 until the slide-shaped elements 40,41 are held in the groove 18.

As the slide-shaped elements 40,41 do not have a bevelled edge 45 on the other side and as the edge of the groove 18 forms a stop, the pen 14 cannot just be drawn like that out of the bore hole 17.

Thus, the fixing pen 14 is solidly connected to the USB stick 1 in this way.

The above-described mechanism can be easily applied in the cap 4 during the assembly of the USB stick 1 in the following way.

On the side which is directed towards the bore hole 17 during the assembly, the body 23 is provided with a U-shaped recess in which the slide-shaped elements 40,41 can be provided with the springs 44.

This recess has such a shape and dimensions that the studs 46 but not the bodies of the slide-shaped elements 40,41 can protrude laterally from the U-shaped recess of the body 23.

When inserting the slide-shaped elements 40,41 and the springs 44 in the body 23, the springs must be slightly tightened.

The control buttons 24 are not yet mounted on the studs 46 then.

In order to push the body 23 via the open side in the cap 4, the studs 46 must be pushed further in the body 23, such that the body 23 can be provided in the cap 4.

As soon as the body 23 has been pushed sufficiently far in the cap 4, such that the studs 46 are situated at the passages provided in the cap to that end, the springs 44 will be released and they will push the studs 46 through the passages 32 to the outside of the USB stick 1.

The control buttons 24 can then be mounted on the studs 46, for example by means of gluing or by means of a threaded connection.

In a variant of the present embodiment, it is possible to execute only one element 40,41 in a moveablemanner, whereby the other element 41,40 assuming a fixed position. In such an embodiment, only one control button may be sufficient.

Thanks to the composition of the different mechanisms, the USB stick can be attached to an object without thereby having to use the control buttons 24.

In the embodiments shown in the figures, the USB stick 1 is secured against any accidental detachments, since the pen 14 can only be detached when both control buttons 24 are simultaneously pressed.

According to the invention, it is not excluded to provide the fixing means on the housing 2.

Nor is it excluded according to the invention to provide the housing 2 of the USB plug with an opening in the shape of a viewing window, whereby the USB stick 1 may further be provided with a led situated behind the viewing window, and which may indicate whether the USB stick 1 is either or not in use.

Although the embodiments shown in the figures have two control buttons 24, it is not excluded according to the invention to provide only one control button 24 and to further simplify the fastening mechanism.

The characteristics that have been described in the different variants can be combined to thus obtain other variants of the embodiment. Such variants are also within the scope of the present invention.

The present invention is by no means restricted to the embodiment described by way of example and represented in the accompanying drawings; on the contrary, such a USB stick according to the invention can be made in all sorts of shapes and dimensions while still remaining within the scope of the invention.

## Claims

1. USB stick (1) of the type which mainly consists of a housing (2) with a memory and a USB plug (3) protruding from an edge of the housing (2) and a cap (4) which can be provided over the USB plug (3) with an open side so as to protect the latter, USB stick (1) being provided with means which connect the housing (2) and the cap (4), in the open as well as in the closed position, and the above-mentioned means consisting of two parallel arms (5) which are fixed to the cap (4) and which, in relation to the above-mentioned open side, protrude from the cap (4) over a length, the housing (2) with the USB plug (3) being slidable between said arms (5) in the longitudinal direction of said arms (5) and being rotatable as well, and the housing (2) being slidable by means of at least two protrusions (8), each on a side edge of the housing (2), which protrusions (8) are mounted slidably in a groove (6) in the sides of the above-mentioned arms (5) which are directed towards one another, **characterised in that** the protrusions (8) are provided at the corners of the housing (2) on the edge from which the USB plug (3) protrudes and **in that** protrusions (10) are also provided at the other corners of the housing (2), which are each held in a recess (11) in the side edges of the housing (2) and which can be pressed against the force of a spring (13) situated under the protrusion (10) in the recess (11) concerned.

2. USB stick (1) according to claim 1, **characterised in that** the housing (2) is rotatable over 180°.

3. USB stick (1) according to claim 1 or 2, **characterised in that** the housing (2) is slidable over a length which is sufficient to pull the USB plug (3) out of the cap (4).

4. USB stick (1) according to any one of the preceding claims, **characterised in that** the above-mentioned protrusions (8) are balls which are partly held in a recess (9) in the above-mentioned side edges of the housing (2).

5. USB stick according to any one of the preceding claims, **characterised in that** the grooves (6) are provided with a stop (7) at the free far ends of the arms (5) for the sliding movement of the above-mentioned protrusions (8).

6. USB stick (1) according to any one of the preceding claims combined with claim 2, **characterised in that** the housing (2) of the USB stick (1) is locked in a rotated, ready-for-use condition in the longitudinal direction by the protrusions (10) situated at the corners of the other edge than the one from which the USB plug (3) protrudes.

7. USB stick (1) according to any one of the preceding claims, **characterised in that** the USB stick (1) is provided with means for an at least temporary attachment of the USB stick (1) to another object, these means being detachable.

8. USB stick (1) according to claim 7, **characterised in that** the above-mentioned attaching means comprise a pen (14) which fits in a bore hole (17) in the USB stick (1), which bore hole (17) is provided with an at least radially directed seat (19) for a ball (20) or a pen (33) which can co-operate with a groove (18) by means of a spring (21) along the perimeter of a far end of the pen (14) so as to lock the latter.

9. USB stick (1) according to claim 8, **characterised in that** means are provided to eliminate the action of the spring (21) on the ball (20) or the pen (33).

10. USB stick (1) according to claim 9, **characterised in that** the above-mentioned means are formed of an element (22) provided between the ball (20) or the pen (33) and the spring (21) and a mechanism which makes it possible to draw the element (22) out of the bore hole (17).

11. USB stick (1) according to claim 10, **characterised in that** said mechanism consists of a control button (24) which is connected to a gear rack (26) working in conjunction with a gear wheel (28) which in turn works in conjunction with a gear rack (27) which is connected to the above-mentioned element (22) between the spring (21) and the ball (20) or the pen (33), such that when the control button (24) is pressed, the element (22) is withdrawn from the bore hole (17).

12. USB stick (1) according to claim 7, **characterised in that** the above-mentioned attaching means comprise a pen (14) which fits in a bore hole (17) in the USB stick (1), whereby elements (40,41) are provided in the cap (4) such that they can slide in each other's prolongation between at least two positions, namely a first position of rest in which the elements (40,41) are pushed away from each other under the influence of at least one spring (44) and in which position the elements (40,41) define together an opening having a first diameter, and a second position in which the elements (40,41) are pushed towards one another by pressing at least one laterally protruding control button (24) and in which second position the elements (40,41) define together an opening having a second diameter which is larger than the first diameter, the second diameter being larger than the pen (14) and the first diameter being smaller than the diameter of the pen (14) but larger than the diameter of a circumferential groove (18) provided on the head of the pen (14).

13. USB stick (1) according to claim 12 **characterised in that** the first and the second diameter are obtained as the elements (40,41) are provided partly overlapping in their longitudinal direction, and **in that** in each of the elements (40,41) in the overlapping parts are provided two semi-circular passages, semi-circular passages with the smallest diameter being positioned further from the control button (24) with their centre than the semi-circular passages with the largest diameter.

## Patentansprüche

1. USB-Stick (1) des Typs, der im Wesentlichen aus einem Gehäuse (2) mit einem Speicher und einem aus einer Kante des Gehäuses (2) ragenden USB-Stecker (3) und einer Kappe (4), die mit einer offenen Seite über dem USB-Stecker (3) angebracht werden kann, um letzteren zu schützen, besteht, wobei der USB-Stick (1) mit Mitteln versehen ist, die das Gehäuse (2) und die Kappe (4) verbinden, sowohl in der offenen als auch in der geschlossenen Position, und wobei die vorgenannten Mittel aus zwei parallelen Armen (5) bestehen, die an der Kappe (4) befestigt sind und die in Bezug auf die vorgenannte offene Seite über eine Länge aus der Kappe (4) ragen, wobei das Gehäuse (2) mit dem USB-Stecker (3) zwischen diesen Armen (5) in der Längsrichtung dieser Arme (5) verschiebbar ist und auch rotierbar ist, und wobei das Gehäuse (2) mittels mindestens zwei Vorsprüngen (8), jeder an einer Seitenkante des Gehäuses (2), verschiebbar ist, welche Vorsprünge (8) verschiebbar in einer Nut (6) in den zueinander gerichteten Seiten der vorgenannten Arme (5) montiert sind, **dadurch gekennzeichnet, dass** die Vorsprünge (8) an den Ecken des Gehäuses (2) angebracht sind, an der Kante, von der der USB-Stecker (3) vorragt, und dass auch an den anderen Ecken des Gehäuses (2) Vorsprünge (10) angebracht sind, die jeder in einer Aussparung (11) in den Seitenkanten des Gehäuses (2) sitzen und die gegen die Kraft einer Feder (13) eingedrückt werden können, die sich unter dem Vorsprung (10) in der betreffenden Aussparung (11) befindet.

2. USB-Stick (1) nach Anspruch 1, **dadurch gekennzeichnet, dass** das Gehäuse (2) über 180° rotierbar ist.

3. USB-Stick (1) nach Anspruch 1 oder 2, **dadurch gekennzeichnet, dass** das Gehäuse (2) über eine Länge verschiebbar ist, die ausreicht, um den USB-Stecker (3) aus der Kappe (4) zu ziehen.

4. USB-Stick (1) nach einem der vorgenannten Ansprüche, **dadurch gekennzeichnet, dass** die vorgenannten Vorsprünge (8) Kugeln sind, die teilweise in einer Ausnehmung (9) in den vorgenannten Seitenkanten des Gehäuses (2) sitzen.

5. USB-Stick (1) nach einem der vorgenannten Ansprüche, **dadurch gekennzeichnet, dass** die Nuten (6) an den freien Enden der Arme (5) mit einem Anschlag (7) für die Schiebebewegung der vorgenannten Vorsprünge (8) versehen sind.

6. USB-Stick (1) nach einem der vorgenannten Ansprüche kombiniert mit Anspruch 2, **dadurch gekennzeichnet, dass** das Gehäuse (2) des USB-Sticks (1) in einem rotierten, betriebsbereiten Zustand in der Längsrichtung durch die Vorsprünge (10) blockiert ist, die sich an den Ecken der anderen Kante befinden als der, von der der USB-Stecker (3) vorragt.

7. USB-Stick (1) nach einem der vorgenannten Ansprüche, **dadurch gekennzeichnet, dass** der USB-Stick (1) mit Mitteln für eine mindestens zeitweilige Befestigung des USB-Sticks (1) an einem anderen Gegenstand versehen ist, wobei diese Mittel lösbar sind.

8. USB-Stick (1) nach Anspruch 7, **dadurch gekennzeichnet, dass** die vorgenannten Befestigungsmittel einen Stift (14) umfassen, der in eine Bohrung (17) in dem USB-Stick (1) passt, welche Bohrung (17) mit einem mindestens radial gerichteten Sitz (19) für eine Kugel (20) oder einen Stift (33) versehen ist, der mittels einer Feder (21) mit einer Nut (18) entlang dem Umfang eines Endes des Stifts (14) zusammenwirken kann, um letzteren zu blockieren.

9. USB-Stick (1) nach Anspruch 8, **dadurch gekennzeichnet, dass** Mittel vorgesehen sind, um das Einwirken der Feder (21) auf die Kugel (20) oder den Stift (33) wegzunehmen.

10. USB-Stick (1) nach Anspruch 9, **dadurch gekennzeichnet, dass** die vorgenannten Mittel aus einem Element (22) bestehen, das zwischen der Kugel (20) oder dem Stift (33) und der Feder (21) angebracht ist, und einem Mechanismus, der zulässt, das Element (22) aus der Bohrung (17) zu ziehen.

11. USB-Stick (1) nach Anspruch 10, **dadurch gekennzeichnet, dass** dieser Mechanismus aus einem Bedienungsknopf (24) besteht, der mit einer Zahnstange (26) verbunden ist, die mit einem Zahnrad (28) zusammenwirkt, das wiederum mit einer Zahnstange (27) zusammenwirkt, die mit dem vorgenannten Element (22) zwischen der Feder (21) und der Kugel (20) oder dem Stift (33) verbunden ist, sodass, wenn der Bedienungsknopf (24) eingedrückt wird, das Element (22) von der Bohrung (17) weggezogen wird.

12. USB-Stick (1) nach Anspruch 7, **dadurch gekennzeichnet, dass** die vorgenannten Befestigungsmittel einen Stift (14) umfassen, der in eine Bohrung (17) in dem USB-Stick (1) passt, wobei in der Kappe (4) Elemente (40, 41) so vorgesehen sind, dass sie in ihrer gegenseitigen Verlängerung zwischen mindestens zwei Positionen verschiebbar sind, nämlich einer ersten Ruheposition, worin die Elemente (40, 41) unter dem Einfluss mindestens einer Feder (44) voneinander weggedrückt werden und in welcher Position die Elemente (40, 41) zusammen eine Öffnung mit einem ersten Durchmesser definieren, und einer zweiten Position, worin die Elemente (40, 41) durch Eindrücken mindestens eines seitlich vorragenden Bedienungsknopfs (24) gegeneinander gedrückt werden und in welcher zweiten Position die Elemente (40, 41) zusammen eine Öffnung mit einem zweiten Durchmesser definieren, der größer als der erste Durchmesser ist, wobei der zweite Durchmesser größer als der Stift (14) ist und der erste Durchmesser kleiner als der Durchmesser des Stifts (14), jedoch größer als der Durchmesser einer am Kopf des Stifts (14) vorgesehenen Umfangsnut (18) ist.

13. USB-Stick (1) nach Anspruch 12, **dadurch gekennzeichnet, dass** der erste und der zweite Durchmesser dadurch erhalten werden, dass die Elemente (40, 41) in ihrer Längsrichtung teilweise überlappend vorgesehen werden, und dadurch, dass in jedem der Elemente (40, 41) in den überlappenden Teilen zwei halbkreisförmige Durchgänge vorgesehen sind, wobei halbkreisförmige Durchgänge mit dem kleinsten Durchmesser mit ihrem Zentrum weiter von dem Bedienungsknopf (24) weg positioniert sind als die halbkreisförmigen Durchgänge mit dem größten Durchmesser.

## Revendications

1. Clé USB (1) du type qui est constitué principalement par un boîtier (2) comportant une mémoire et un connecteur USB (3) faisant saillie par rapport à un bord du boîtier (2) et par un capuchon (4) qui peut venir se placer par-dessus le connecteur USB (3), avec un côté ouvert de façon à pouvoir protéger cette dernière, la clé USB (1) étant munie de moyens qui relient le boîtier (2) et le capuchon (4), aussi bien dans la position ouverte que dans la position fermée, et le moyen susmentionné étant constitué par deux bras parallèles (5) qui sont fixés au capuchon (4) et qui, par rapport au côté ouvert susmentionné, font saillie par rapport au capuchon (4) sur une certaine longueur, le boîtier (2) avec le connecteur USB (3) étant à même de coulisser entre lesdits bras (5) dans la direction longitudinale desdits bras (5) et étant également rotatif, et le boîtier (2) étant à même de coulisser au moyen d'au moins deux saillies (8), une sur chaque bord latéral du boîtier (2), lesdites saillies (8) étant montées en coulissement dans une rainure (6) dans les côtés des bras susmentionnés (5) qui sont orientés l'un vers l'autre, **caractérisée en ce que** les saillies (8) sont prévues aux coins du boîtier (2) sur le bord desquels fait saillie le connecteur USB (3), et **en ce que** les saillies (10) sont également prévues aux autres coins du boîtier (2) qui sont maintenus dans un évidement (11) dans les bords latéraux du boîtier (2) et qui peuvent être comprimés à l'encontre de la force exercée par un ressort (13) qui est situé en dessous de la saillie (10) dans l'évidement (11) concerné.

2. Clé USB (1) selon la revendication 1, **caractérisée en ce que** le boîtier (2) est à même d'effectuer des rotations sur 180°.

3. Clé USB (1) selon la revendication 1 ou 2, **caractérisée en ce que** le boîtier (2) est à même de coulisser sur une longueur qui est suffisante pour tirer le connecteur USB (3) hors du capuchon (4).

4. Clé USB (1) selon l'une quelconque des revendications précédentes, **caractérisée en ce que** les saillies susmentionnées (8) sont des billes qui sont maintenues en partie dans un évidement (9) dans les bords latéraux susmentionnés du boîtier (2).

5. Clé USB (1) selon l'une quelconque des revendications précédentes, **caractérisée en ce que** les rainures (6) sont munies d'un arrêt (7) aux extrémités éloignées libres des bras (5) pour le mouvement de coulissement des saillies susmentionnées (8).

6. Clé USB (1) selon l'une quelconque des revendications précédentes en combinaison avec la revendication 2, **caractérisée en ce que** le boîtier (2) de la clé USB (1) est verrouillé à l'état prêt à l'emploi dans lequel elle a effectué une rotation, en direction longitudinale, par le fait que les saillies (10) sont situées aux coins de l'autre bord par rapport à celui à partir duquel fait saillie le connecteur USB (3).

7. Clé USB (1) selon l'une quelconque des revendications précédentes, **caractérisée en ce que** la clé USB (1) est munie de moyens pour une fixation au moins temporaire de la clé USB (1) à un autre objet, ces moyens étant amovibles.

8. Clé USB (1) selon la revendication 7, **caractérisée en ce que** les moyens de fixation susmentionnés comprennent un stylo (14) qui vient se fixer dans un alésage (17) dans la clé USB (1), l'alésage (17) étant muni d'un siège (19) au moins orienté en direction radiale pour une bille (20) ou pour un stylo (33), qui est à même de coopérer avec une rainure (18) au moyen d'un ressort (21) le long du périmètre de l'extrémité éloignée du stylo (14) de façon à verrouiller le dernier cité.

9. Clé USB (1) selon la revendication 8, **caractérisée en ce que** des moyens sont prévus pour supprimer l'action du ressort (21) s'exerçant sur la bille (20) ou sur le stylo (33).

10. Clé USB (1) selon la revendication 9, **caractérisée en ce que** les moyens susmentionnés sont réalisés à partir d'un élément (22) prévu entre la bille (20) ou le stylo (33) et le ressort (21) et d'un mécanisme qui permet de tirer l'élément (22) hors de l'alésage (17).

11. Clé USB (1) selon la revendication 10, **caractérisée en ce que** ledit mécanisme est constitué par un bouton de commande (24) qui est relié à une crémaillère (26) qui travaille conjointement avec une roue dentée (28) qui travaille à son tour conjointement avec une crémaillère (27) qui est reliée à l'élément (22) susmentionné entre le ressort (21) et la bille (20) ou le stylo (33), tant et si bien que, lorsque le bouton de commande (24) est enfoncé, l'élément (22) est retiré de l'alésage (17).

12. Clé USB (1) selon la revendication 7, **caractérisée en ce que** les moyens de fixation susmentionnés comprennent un stylo (14) qui vient s'insérer dans un alésage (17) dans la clé USB (1), des éléments (40, 41) étant prévus dans le capuchon (4) de façon à pouvoir coulisser dans chaque prolongement réciproque à au moins deux positions, plus précisément une première position de repos dans laquelle les éléments (40, 41) sont poussés à l'écart l'un de l'autre sous l'influence d'au moins un ressort (44) et, première position dans laquelle les éléments (40, 41) définissent ensemble une ouverture possédant un premier diamètre, et une deuxième position dans laquelle les éléments (40, 41) sont poussés l'un vers l'autre en enfonçant au moins un bouton de commande (24) faisant saillie en direction latérale, et deuxième position dans laquelle les éléments (40, 41) définissent ensemble une ouverture possédant un deuxième diamètre qui est supérieur au premier diamètre, le deuxième diamètre étant plus grand que le diamètre du stylo (14) et le premier diamètre étant plus petit que le diamètre du stylo (14), mais plus grand que le diamètre d'une rainure circonférentielle (18) prévue sur la tête du stylo (14).

13. Clé USB (1) selon la revendication 12, **caractérisée en ce qu'**on obtient le premier et le deuxième diamètre lorsqu'on prévoit les éléments (40, 41) dans une position dans laquelle ils se chevauchent en partie dans leur direction longitudinale, et en ce cas dans chacun des éléments (40, 41), dans les parties chevauchantes, on prévoit deux passages semi-circulaires, les passages semi-circulaires possédant le plus petit diamètre étant disposés plus loin du bouton de commande (24) avec leurs centres que les passages semi-circulaires possédant le plus grand diamètre.
